# EUROPEAN PATENT SPECIFICATION

(11) **EP 0 532 203 B1**
(45) Date of publication and mention of the grant of the patent: **30.07.1997**
(21) Application number: 92307796.0
(22) Date of filing: 27.08.1992
(51) Int. Cl.: H03G 3/20, H03G 7/00

(54) **Power controller**
Vorrichtung zur Leistungssteuerung
Réglage de puissance

(30) Priority: 30.08.1991 JP 220507/91
(43) Date of publication of application: 17.03.1993
(73) Proprietor: NEC CORPORATION, Tokyo (JP)
(72) Inventor: Hatakeyama Naoto, c/o NEC Corporation, Minato-ku, Tokyo (JP)
(74) Representative: Moir, Michael Christopher

(56) References cited:
- EP-A- 0 135 154
- EP-A- 0 446 073
- GB-A- 1 108 370
- GB-A- 2 238 435
- US-A- 4 476 437

## Description

### Background of the Invention

The present invention relates to a power controller for mobile radio communication and, more particularly, to a power controller for controlling a high-frequency power of a high-frequency power amplifier such as a mobile telephone unit.

A conventional power controller includes a detector for extracting a part of a high-frequency power output from a power amplifier and detecting the power, a power control unit for comparing the detection voltage with a predetermined reference voltage to control a feedback operation of the high-frequency power output, and a digital/analog converter for generating the reference voltage in response to a digital signal output from an external circuit, thereby setting a target output power at a constant voltage.

In the above conventional power controller, a change in high-frequency power caused by a change in control voltage of the power amplifier itself tends to be small at about 80 to 90% of a rated output and to be large at about 20 to 30% of the rated output, therefore, causing a large difference in sensitivity. For this reason, in the digital/analog converter for outputting a reference voltage, its resolution must be increased to match a region having a high sensitivity. Since this resolution is kept unchanged in a region having a low sensitivity, bits are excessively used due to multi-stage power-down. In addition, a change in detection voltage output caused by a change in high-frequency power passing through the detector is on the order of several hundreds mV at about 80 to 90% of the rated output, and the change in detection voltage output is on the order of several mV at about 20 to 30% of the rated output with the same rate of the high-frequency power. For this reason, a difference in sensitivity occurs, and the same problem as described above is posed. In this specification "sensitivity" means the change in output per unit input, and "resolution" means the change in input necessary to produce a unit change in output. Thus resolution is the reciprocal of sensitivity.

EP-A-0135154 discloses transmission output power control apparatus of the type comprising a voltage variable attenuator inputted with a transmission signal, a power amplifier amplifying the output of the attenuator, a detector detecting a power of the output of the power amplifier, a reference voltage generator. A comparator is provided for comparing the outputs of the detector and the reference voltage generator for producing an error signal. A DC amplifier is provided for amplifying the error signal, the output of the DC amplifier being supplied to the voltage variable attenuator for controlling either one or both of the input level and output gain of the power amplifier.

GB-A-1108370 relates to an adjustable attenuating arrangement adapted to produce any of a plurality of predetermined values of attenuation lying on a curve of attenuation consisting of a series of substantially linear portions between successive pairs of attenuation values in geometrical progression.

It is an object of the present invention to provide a power controller capable of decreasing the number of bits used for a digital/analog converter.

It is another object of the present invention to provide a power controller capable of obtaining a predetermined stable high-frequency power.

It is still another object of the present invention to provide a power controller having a constant sensitivity regardless of a change in level of a high-frequency power.

In order to achieve the above objects, according to the present invention, there is provided a power controller having:
power amplifying means for amplifying a signal input in response to an applied control voltage (Valc) to produce a power output (Pout);
detecting means for detecting the power output (Pout) from said power amplifying means to produce a detection voltage (Vdet); and
power control means for comparing a reference voltage with the detection voltage from said detecting means to produce the control voltage;
said power amplifying means, detecting means, and power control means forming a closed-loop feedback system in which the sensitivity of the power output to feedback varies with the power output level;
characterised by digital/analog converting means for converting externally input digital data into said reference voltage, said converting means having a non-linear conversion characteristic wherein the sensitivity of the reference voltage (Vref) to a change in the digital data (10) is set to be high when the said sensitivity of the power output (Pout) to feedback is low, and is set to be low when the said sensitivity of the power output to feedback is high.
Fig. 1 is a block diagram showing a power controller according to an embodiment of the present invention;
Fig. 2A is a graph showing characteristics of a power amplifier of a power controller according to the present invention;
Fig. 2B is a graph showing characteristics of a digital/analog converter;
Fig. 3A is a graph showing characteristics of a detector of a power controller according to another embodiment of the present invention; and
Fig. 3B is a graph showing characteristics of a digital/analog converter of the power controller according to the embodiments shown in Fig. 3A.

### Description of the Preferred Embodiments

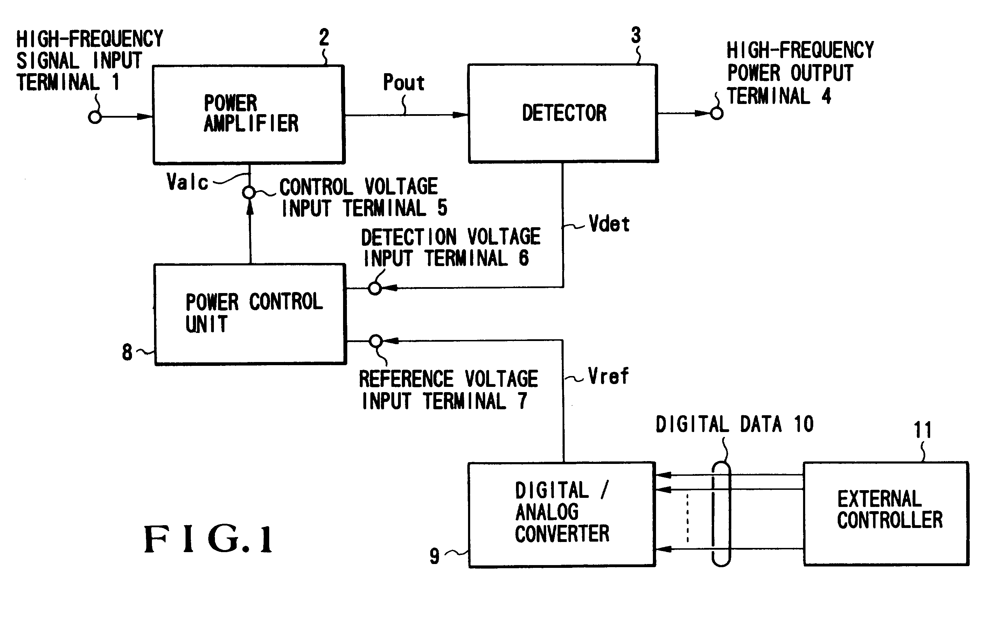

An embodiment of the present invention will be described below with reference to the accompanying drawings. Fig. 1 shows a power controller according to an embodiment of the present invention.

In Fig. 1, the power controller includes a high-frequency signal input terminal 1 for receiving a high-frequency signal, a power amplifier 2 for receiving the high-frequency signal from the high-frequency signal input terminal 1 and amplifying the high-frequency signal on the basis of an applied control voltage Valc to output a high-frequency power Pout, a detector 3 for detecting the high-frequency power Pout from the power amplifier 2 to output a detection voltage Vdet, a digital/analog converter 9 for parallelly receiving digital data 10 consisting of a plurality of bits output from an external controller 11 to output a reference voltage Vref, and a power control unit 8 for comparing the reference voltage Vref from the digital/analog converter 9 with the detection voltage Vdet from the detector 3 to output the control voltage Valc to the power amplifier 2. Reference numeral 4 denotes a high-frequency power output terminal; 5, a control voltage input terminal; 6, a detection voltage input terminal; and 7, a reference voltage input terminal.

As the characteristic feature of the present invention, the conversion characteristic curve of the digital/analog converter 9 have nonlinearity which compensates for the characteristic curve of the high-frequency power Pout with reference to the control voltage Valc in the power amplifier 2.

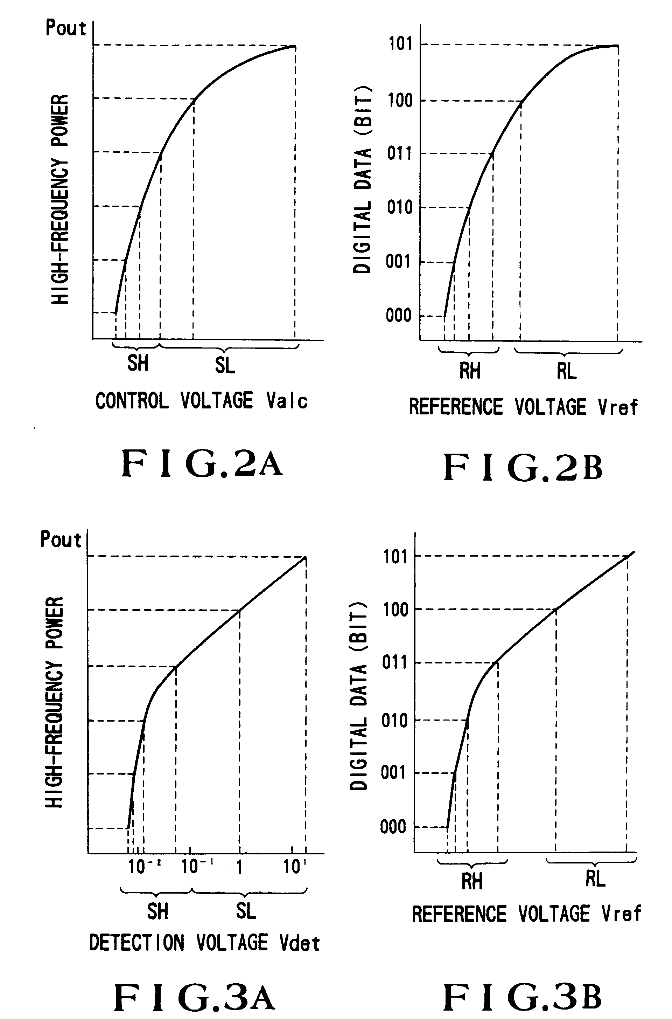

An operation of the power controller with the above arrangement will be described below. Figs. 2A and 2B show characteristics of the power amplifier and the digital analog converter in the power controller according to the present invention.

In Fig. 1, a feedback control operation is performed by the power amplifier 2, the detector 3, and the power control unit 8 in the same manner as in a conventional power controller. The power controller of this embodiment is constituted by adding the digital/analog converter 9 having characteristics (to be described later). The external controller 11 outputs the digital data 10 which is linearly changed in proportion to'the required magnitude of high-frequency power to be externally output from, e.g., the high-frequency power output terminal 4. The digital/analog converter 9 converts the digital data 10 into the reference voltage Vref on the basis of predetermined conversion characteristics (to be described later) to output it to the power control unit 8.

Fig. 2A shows characteristics of the high-frequency power Pout with respect to the control voltage Valc in the power amplifier 2. Fig. 2B shows characteristics of the reference voltage Vref with respect to the digital data 10 in the digital/analog converter 9.

In correspondence with a high sensitivity region SH in the characteristics of Fig. 2A, an output from the digital/analog converter 9 increases the resolution of each bit as a function of the reference voltage Vref as indicated by RH in Fig. 2B. In addition, in correspondence with a low sensitivity region SL in characteristics of Fig. 2A, the output from the digital/analog converter 9 decreases the resolution of each bit as a function of the reference voltage Vref as indicated by RL in Fig. 2B.

That is, the conversion characteristics of the digital/analog converter 9 are set such that its sensitivity (i.e. the rate of change in the reference voltage Vref corresponding to the change in digital data)is set to be low in the high sensitivity region SH of the power amplifier 2 and is set to be high in the low sensitivity region SL. Thus the digital/analog converter has high resolution for the high sensitivity region SH and low resolution for the low sensitivity region SL.

Figs. 3A and 3B show characteristics of a detector and a digital/analog converter of a power controller according to another embodiment of the present invention. Fig. 3A shows characteristics of a high-frequency power Pout passing through a detector 3 as a function of a detection voltage Vdet shown in Fig. 1. Fig. 3B shows the sensitivity characteristics of a reference voltage Vref as a function of digital data 10 in a digital/analog converter 9.

In correspondence with a high sensitivity region SH in the characteristics of Fig. 3A, an output from the digital/analog converter 9 increases the resolution of each bit as a function of the reference voltage Vref as indicated by RH in Fig. 3B, that is to say decreasing the sensitivity of Vref to the digital data 10. In addition, in correspondence with a low sensitivity region SL in the sensitivity characteristic of Fig. 3A, the output from the digital/analog converter 9 decreases the resolution of each bit as a function of the reference voltage Vref as indicated by RL in Fig. 3B.

That is, the conversion characteristics of the digital/analog converter 9 are set such that the sensitivity (rate of change in the reference voltage Vref corresponding to the change in digital data) is set to be low in the high sensitivity region SH of the detector 3 and is set to be high in the low sensitivity region SL.

As described above, since the characteristics of the power amplifier 2 shown in Fig. 2A are approximated to compensate for those of the detector 3 shown in Fig. 3A, the conversion characteristics of the digital/analog converter 9 is matched with the characteristics of the power amplifier 2 or the detector 3.

That is, the conversion characteristics of the digital/analog converter 9 are set such that the rate of change in the reference voltage Vref corresponding to the change in digital data is set to be high in the high resolution (low sensitivity) SL region of a feedback system including a power amplifier 2, the detector 3, and a power control unit 8 and is set to be low in the low resolution (high sensitivity) region SH.

As described above, according to the present invention, bits need not consumed exceeding the required number of bits by the digital/analog converter, a desired constant high-frequency power can be advantageously obtained by a small number of bits.

## Claims

1. A power controller having:
power amplifying means (2) for amplifying a signal input in response to an applied control voltage (Valc) to produce a power output (Pout);
detecting means (3) for detecting the power output (Pout) from said power amplifying means to produce a detection voltage (Vdet); and
power control means (8) for comparing a reference voltage (Vref) with the detection voltage from said detecting means to produce the control voltage;
said power amplifying means, detecting means, and power control means forming a closed-loop feedback system in which the sensitivity of the power output to feedback varies with the power output level;
characterised by digital/analog converting means (9) for converting externally input digital data into said reference voltage, said converting means (9) having a non-linear conversion characteristic wherein the sensitivity of the reference voltage (Vref) to a change in the digital data (10) is set to be high when the said sensitivity of the power output (Pout) to feedback is low, and is set to be low when the said sensitivity of the power output to feedback is high.

2. A controller according to Claim 1, wherein said non-linear conversion characteristic is approximated to compensate for the response characteristic of the power output (Pout) to the control voltage (Valc) of the power amplifying means (2).

3. A controller according to Claim 1, wherein said non-linear conversion characteristic is approximated to compensate for the response characteristic of the power output (Pout) to the detection voltage (Vdet) of said detecting means (3).

4. A controller according to any preceding claim, wherein the digital data is input from external control means (11), said digital data being linearly related to the required power output.

5. A controller according to any preceding claim, wherein the signal input is a radio frequency signal and the power output is a radio frequency power output.

6. A controller according to Claim 1, wherein said digital/analog converting means (9) has nonlinear conversion characteristics approximated to compensate for the response characteristic of the high frequency power output to the detection voltage, for converting externally input digital data of a small number of bits into a reference voltage on the basis of said conversion characteristics and outputting the reference voltage.

7. A controller according to Claim 1, wherein said digital/analog conversion means (9) has nonlinear conversion characteristics approximated to compensate for the response characteristic of the high-frequency power output to the control voltage (Valc), for converting externally input digital data of a small number of bits into a reference voltage on the basis of said conversion characteristics and outputting the reference voltage.

8. A controller according to Claim 6 or 7, wherein said digital/analog converting means (9), has a conversion characteristics in which a rate of change in reference voltage corresponding to a change of the input in digital data is set to be low in a high sensitive output region of said feedback system including said power amplifying means, said detecting means, and said power control means, to increase a resolution of each bit of the input digital data, and is set to be high in a low sensitive output region of the feedback system to decrease the resolution of each bit of the input digital data.

9. A controller according to Claim 8, wherein further comprising external control means for outputting the digital data to said digital/analog converting means, the input digital data being set to obtain a required value of the power signal from said detection means as an independent variable of the feedback system.

## Patentansprüche

1. Vorrichtung zur Leistungssteuerung, die aufweist:
Leistungsverstärkungsmittel (2) zum Verstärken eines Signaleingangssignals als Reaktion auf eine angelegte Steuerspannung (Valc) zum Erzeugen eines Leistungsausgangssignals (Pout);
Erfassungsmittel (3) zum Erfassen des Leistungsausgangssignals (Pout) von den Leistungsverstärkungsmitteln zum Erzeugen einer Erfassungsspannung (Vdet); und
Leistungssteuermittel (8) zum Vergleichen einer Bezugspannung (Vref) mit der Erfassungsspannung von den Erfassungsmitteln zum Erzeugen der Steuerspannung;
wobei die Leistungsverstärkungsmittel, die Erfassungsmittel und die Leistungssteuermittel ein Rückkopplungssystem mit geschlossener Schleife bilden, bei dem die Empfindlichkeit des Leistungsaugangssignals auf die Rückkopplung mit dem Leistungsausgangspegel variiert;
gekennzeichnet durch Digital/Analogwandlermittel (9) zum Umwandeln von extern eingegebenen Digitaldaten in die Bezugspannung, wobei die Wandlermittel (9) eine nicht-lineare Umwandlungscharakteristik haben, wobei die Empfindlichkeit der Bezugspannung (Vref) auf eine Änderung in den Digitaldaten (10) hoch eingestellt ist, wenn die Empfindlichkeit des Leistungsausgangssignals (Pout) auf die Rückkopplung niedrig ist, und niedrig eingestellt ist, wenn die Empfindlichkeit des Leistungsaugangssignals auf die Rückkopplung hoch ist.

2. Steuerungsvorrichtung nach Anspruch 1, bei der die nicht-lineare Umwandlungscharakteristik approximiert wird, um die Ansprechcharakteristik des Leistungsausgangssignals (Pout) auf die Steuerspannung (Valc) der Leistungsverstärkungsmittel (2) zu kompensieren.

3. Steuerungsvorrichtung nach Anspruch 1, bei der die nicht-lineare Umwandlungscharakteristik approximiert wird, um die Ansprechcharakteristik des Leistungsausgangssignals (Pout) auf die Erfassungsspannung (Vdet) der Erfassungsmittel (3) zu kompensieren.

4. Steuerungsvorrichtung nach einem vorangehenden Anspruch, bei der die digitalen Daten von externen Steuermitteln (11) eingegeben werden, wobei die Digitaldaten linear mit dem erforderlichen Leistungsausgangssignal in Beziehung stehen.

5. Steuerungsvorrichtung nach einem vorangehenden Anspruch, bei der das Eingangssignal ein Radiofrequenzsignal ist und das Leistungsausgangssignal ein Radiofrequenzleistungsausgangsignal ist.

6. Steuerungsvorrichtung nach Anspruch 1, bei der die Digital/Analogwandlermittel (9) nicht-lineare Umwandlungscharakteristiken haben, die approximiert sind, um die Ansprechcharakteristik des Hochfrequenzleistungsausgangssignals auf die Erfassungsspannung zu kompensieren, um extern eingegebene Digitaldaten einer kleinen Anzahl von Bits in eine Bezugspannung aufgrund der Umwandlungscharakteristiken umzuwandeln und die Bezugspannung auszugeben.

7. Steuerungsvorrichtung nach Anspruch 1, bei der die Digital/Analogwandlermittel (9) nicht-lineare Umwandlungscharakteristiken haben, die approximiert sind, um die Ansprechcharakteristik des Hochfrequenzleistungsausgangssignals auf die Steuerspannung (Valc) zu kompensieren, um extern eingegebene Digitaldaten einer kleinen Anzahl von Bits in eine Bezugspannung aufgrund der Umwandlungscharakteristiken umzuwandeln und die Bezugspannung auszugeben.

8. Steuerungsvorrichtung nach Anspruch 6 oder 7, bei der die Digital/Analogwandlermittel (9) eine Umwandlungscharakteristik haben, bei der eine Änderungsrate in der Bezugspannung, die einer Änderung der Eingabe von Digitaldaten entspricht, niedrig in einem hochempfindlichen Ausgangsbereich des Rückkopplungssystems, das die Leistungsverstärkungsmittel, die Erfassungsmittel und die Leistungssteuermittel einschließt, eingestellt ist, um die Auflösung jedes Bits der eingegebenen Digitaldaten zu erhöhen, und hoch in einem wenig empfindlichen Ausgangsbereich des Rückkopplungssystems eingestellt ist, um die Auflösung jedes Bits der eingegebenen Digitaldaten zu verringern.

9. Steuerungsvorrichtung nach Anspruch 8, die weiter externe Steuermittel aufweist, um die Digitaldaten zu den Digital/Analogwandlermitteln auszugeben, wobei die eingegebenen Digitaldaten eingestellt werden, um einen erforderlichen Wert des Leistungssignals von den Erfassungsmitteln als eine unabhängige Variable des Rückkopplungssystems zu erhalten.

## Revendications

1. Commande de puissance comportant :
des moyens d'amplification de puissance (2) pour amplifier une entrée de signal en réponse à une tension de commande appliquée (Valc) pour produire une sortie de puissance (Pout),
des moyens de détection (3) pour détecter la sortie de puissance (Pout) desdits moyens d'amplification de puissance pour produire une tension de détection (Vdet), et
des moyens de commande de puissance (8) pour comparer une tension de référence (Vref) à la tension de détection desdits moyens de détection pour produire la tension de commande,
lesdits moyens d'amplification de puissance, lesdits moyens de détection et lesdits moyens de commande de puissance formant un système de rétroaction en boucle fermée dans lequel la sensibilité de la sortie de puissance pour rétroaction varie avec le niveau de la sortie de puissance,
caractérisée par des moyens de conversion numérique/analogique (9) pour convertir des données numériques entrées depuis l'extérieur en ladite tension de référence, lesdits moyens de conversion (9) ayant une caractéristique de conversion non-linéaire dans laquelle la sensibilité de la tension de référence (Vref) à un changement dans les données numériques (10) est établie pour être élevée lorsque ladite sensibilité de la sortie de puissance (Pout) pour rétroaction est faible, et est établie pour être faible lorsque ladite sensibilité de la sortie de puissance pour rétroaction est élevée.

2. Commande selon la revendication 1, dans laquelle ladite caractéristique de conversion non-linéaire est approximée pour compenser la caractéristique de réponse de la sortie de puissance (Pout) à la tension de commande (Valc) des moyens d'amplification de puissance (2).

3. Commande selon la revendication 1, dans laquelle ladite caractéristique de conversion non-linéaire est approximée pour compenser la caractéristique de réponse de la sortie de puissance (Pout) à la tension de détection (Vdet) desdits moyens de détection (3).

4. Commande selon l'une quelconque des revendications précédentes, dans laquelle les données numériques sont entrées à partir de moyens de commande externes (11), lesdites données numériques étant linéairement en relation avec la sortie de puissance requise.

5. Commande selon l'une quelconque des revendications précédentes, dans laquelle le signal d'entrée est un signal de fréquence radio et la sortie de puissance est une sortie de puissance de fréquence radio.

6. Commande selon la revendication 1, dans laquelle lesdits moyens de conversion numérique/analogique (9) ont des caractéristiques de conversion non-linéaires approximées pour compenser la caractéristique de réponse de la sortie de puissance haute-fréquence à la tension de détection, pour convertir des données numériques entrées depuis l'extérieur, constituées d'un petit nombre de bits, en une tension de référence sur la base desdites caractéristiques de conversion et délivrer en sortie la tension de référence.

7. Commande selon la revendication 1, dans laquelle lesdits moyens de conversion numérique/analogique (9) ont des caractéristiques de conversion non-linéaires approximées pour compenser la caractéristique de réponse de la sortie de puissance haute-fréquence à la tension de commande (Valc), pour convertir des données numériques entrées depuis l'extérieur, constituées d'un petit nombre de bits, en une tension de référence sur la base desdites caractéristiques de conversion et délivrer en sortie la tension de référence.

8. Commande selon la revendication 6 ou 7, dans laquelle lesdits moyens de conversion numérique/analogique (9) ont des caractéristiques de conversion dans lesquelles un taux de variation de la tension de référence correspondant à un changement de l'entrée de données numériques est établi pour être faible dans un domaine de sortie de sensibilité élevée dudit système de rétroaction, incluant lesdits moyens d'amplification de puissance, lesdits moyens de détection et lesdits moyens de commande de puissance, pour augmenter la résolution de chaque bit des données numériques entrées, et est établi pour être élevé dans un domaine de sortie de sensibilité faible du système de rétroaction pour diminuer la résolution de chaque bit des données numériques entrées.

9. Commande selon la revendication 8, comportant de plus des moyens de commande externes pour délivrer en sortie les données numériques aux moyens de conversion numérique/analogique, les données numériques entrées étant établies pour obtenir une valeur requise du signal de puissance à partir desdits moyens de détection en tant que variable indépendante du système de rétroaction.
